# EUROPEAN PATENT APPLICATION

(11) **EP 4 742 141 A2**
(43) Date of publication of application: **13.05.2026**
(21) Application number: 26153615.5
(22) Date of filing: 22.10.2024
(51) Int. Cl.: G06Q 50/06

(54) **METHOD AND SYSTEM FOR DETERMINING NON-TECHNICAL ENERGY LOSSES IN AN ELECTRICAL ENERY DISTRIBUTION NETWORK**

(30) Priority: 16.01.2024 IT 202400000723
(62) Divisional of application: 24813504.8
(71) Applicant: Enel Grids S.r.l., 00198 Roma (IT)
(72) Inventor: Talucci, Fabio, 00198 Roma (IT); Veronese, Fabio, 00198 Roma (IT); Tarantino, Sergio, 00198 Roma (IT); Guglietti, Fabrizio, 00198 Roma (IT); Vaccari, Stefano, 00198 Roma (IT)
(74) Representative: Petraz, Gilberto Luigi

(57) **Abstract**

Method for determining losses due to non-physical and non-systematic effects of electrical energy in an electrical distribution network, which network comprises a plurality of stations for measuring time series of electrical parameters which characterize the consumption of electrical energy at said measuring stations and wherein data relating to one or more of said electrical parameters are analyzed to determine whether any loss of energy is due to a systematic physical factor or to an anomaly resulting from incidental malfunctions of the network or from abusive withdrawals of electricity, said analysis being performed by means of a machine learning algorithm trained to classify said data as relating to losses due to systematic physical effects or losses due to malfunctions of the network or to actions of abusive energy withdrawals, and wherein said algorithm consists of a so-called autoencoder, which is trained on a dataset comprising at least said one or more electrical parameters.

## Description

### FIELD OF THE INVENTION

The present invention concerns a method for determining losses, due to non-physical and non-systematic effects, of electrical energy in an electrical distribution network, which network comprises a plurality of stations measuring time series of different electrical parameters which characterize the conditions of withdrawal of the electrical energy in the various stations, and the time trend of the quantity of electrical energy withdrawn measured at the various stations, i.e. the consumption of electrical energy at the measuring stations, and wherein at least the data relating to one or more of the electrical parameters and/or the time trend of the quantity of electrical energy withdrawn from the network in correspondence with the one or more measuring stations, together with the context data of the meter (meter demographic data, distribution contract details, etc.), are analyzed to determine whether any loss of energy is due to a systematic physical factor or to an anomaly resulting from incidental malfunctions of the network and/or of the measuring systems, or is due to abusive withdrawals of electrical energy, the analysis being performed by means of a machine learning algorithm trained to classify the one or more measured data as relating to losses due to systematic physical effects, or losses due to malfunctions of the network components (measuring apparatuses), or due to actions of abusive energy withdrawals.

The present invention addresses the technical problem known as the "Energy Recovery Problem", i.e. the problem of identifying and evaluating anomalies and potential frauds by analyzing the behavior relating to energy consumption and other data provided by measuring devices, and also relating to customer domain, with the ultimate aim of billing utilities for the amount of unrecorded energy.

### BACKGROUND OF THE INVENTION

Document WO2014043287 discloses the use of predictive artificial intelligence or machine learning algorithms to determine the probability that a loss of energy is due to non-technical causes, such as those defined above, in order to determine which utilities are the most likely cause of such non-technical losses.

Document WO2014043287 addresses, in greater detail, the use of statistical tools to calculate the probabilities that there are non-technical losses in the network, and only superficially mentions analysis tools that use machine learning or artificial intelligence algorithms, indicating them as potential alternative technologies to statistical tools.

In the state of the art there are systems and methods that provide to use a supervised classifier that is trained on the basis of training databases which comprise, as input data, a combination of data including at least user profiling data, data on the operating conditions of the network and the operating units provided therein, and data on measurements of the energy withdrawn from the network, while as output data they provide the indication of an evaluation made with alternative tools regarding the condition of whether the input data configure non-technical losses or normal technical losses resulting from systematic physical effects.

The solutions proposed in relation to using systems that operate using artificial intelligence algorithms, and in particular machine learning algorithms, are theoretically possible solutions, but they have drawbacks with regard to the specific selection of the algorithm used since it does not appear suitable, due to its nature, for the practical conditions that define the problem.

In fact, the systems that provide to use machine learning algorithms with supervised training have a number of important limitations.

A first drawback lies in the fact that supervised training, such as a classifier or suchlike, requires a large number of training records for which the evaluation regarding the type of loss, i.e. the presence or absence of a non-technical loss as detected by an on-site inspection, is known in relation to the input data. Since the correctness of this training data is essential for the correct training of the algorithm, it is necessary that the expected outputs for the various inputs are correct.

In this specific case, the reliable determination of the outputs, as an evaluation of the presence or absence of a non-technical loss, requires the intervention of human personnel, and in the worst case even technical inspections to verify the conditions of the sampling points, i.e. the meters or other measuring stations. Therefore, generating a training database of size and quality suitable to solve the problem described above through the supervised training of a classifier and/or regressor is a long and expensive process.

Even acknowledging that this supervised training process has to only be done once, and that after this the use of the algorithm with new data admittedly allows to keep the output provided increasingly efficient and precise, so that it can be worth investing in long times and high costs, the supervised system suffers from an intrinsic systematic drawback that is known as "selection bias". The training data consists in fact of data relating to past inspections that had been carried out to verify measuring devices with potentially suspicious results based on the analyses.

Therefore, the measuring devices being inspected are more likely to be associated with abnormal or fraudulent behavior than all the measuring devices present in the network. As a result, a training dataset based on the data relating to the utilities associated with these devices may only be partly representative of the overall utility set. The algorithm model trained with these training datasets is therefore trained to recognize suspicious energy withdrawal points, instead of being trained to recognize suspicious behavior from consumption profiles and other additional data.

A similar consideration applies to the back testing procedure and to the determination of KPIs that are used to evaluate the efficiency of the model, and that may not be representative of the actual in field performance of the model itself.

Document CN 112 098 714 A discloses a method for detecting electricity theft based on ResNet-LSTM, which is a hybrid neural network in which the ResNet model and the LSTM model are combined to provide the extraction capability of the electricity theft detection model. Electricity consumption data is acquired through physical measurements, for example through meters or smart meters.

Document US 2022/247644 A1 discloses a computer-implemented method that applies machine learning to detect and attribute network outages to specific components or nodes within the network. The method described in this document comprises: mapping a network comprising a plurality of islands capable of dynamically changing by subdividing and/or merging one or more islands, wherein the plurality of islands comprises a plurality of individual components; and detecting and localizing one or more local events at the individual component level, as well as at the island level, using a disaggregation model. This document provides a latent variable machine learning model as a disaggregation model to manage complex logical problems, this model is applied to the predictive maintenance of networked systems, such as electrical networks or telecommunications networks.

Document CN 110 658 373 A discloses a model for monitoring electrical energy theft in the distribution network based on the fusion of several algorithms.

Document US 2014/074670 A1 discloses a method for estimating recoverable revenues from non-technical losses within an energy distribution infrastructure.

There is therefore the technical problem of providing a system in which it is possible to use machine learning algorithms, the perimeter of the training data being within the set of meters belonging to the distribution network in question instead of the history of the inspections relating to some potentially suspicious meters.

### SUMMARY OF THE INVENTION

The present invention is set forth and characterized in the independent claims. The dependent claims describe other characteristics of the present invention or variants to the main inventive idea.

Embodiments described herein relate to a method for determining losses, due to non-physical and non-systematic effects, of electrical energy in an electrical distribution network, which network comprises a plurality of stations measuring time series of different electrical parameters which characterize the conditions of withdrawal of the electrical energy in the various stations and the time trend of the quantity of electrical energy withdrawn measured at the various stations, i.e. the consumption of electrical energy at the measuring stations together with the context data of the meter (meter demographic data, distribution contract details, etc.), and wherein at least the data relating to one or more of the electrical parameters and/or the time trend of the quantity of electrical energy withdrawn from the network in correspondence with the one or more measuring stations are analyzed to determine whether any loss of energy is due to a systematic physical factor or to an anomaly resulting from incidental malfunctions of the network or from abusive withdrawals of electrical energy, the analysis being performed by means of a machine learning algorithm trained to classify the one or more measured data as relating to losses due to systematic physical effects, or losses due to malfunctions of the network or to actions of abusive energy withdrawals, and wherein the algorithm comprises a so-called autoencoder, which is trained on a dataset comprising at least the one or more electrical parameters and the data relating to the measurements of the trends of the electrical energy withdrawn from the network or consumption.

An autoencoder is a type of artificial neural network used to learn efficient encodings of unlabeled data, thus falling within the realm of unsupervised learning. The encoding is validated and refined by attempting to reconstruct the input from the encoding. The autoencoder learns a representation (encoding) of a set of data, typically through a reduction of the dimensionality of the input data (i.e. learning a mapping of the input data on a lower-dimensional representation than the initial input), training the network to ignore insignificant data ("noise"). More details are described in the public document available on the web at https://en.wikipedia.org/wiki/Autoencoder.

According to another characteristic, the autoencoder training is performed using records comprising
data from different datasets and consisting at least of data relating to the electrical parameters of the supply and to the time trend of the energy withdrawn, relative to all the historical cases that have been the subject of inspection and for which the output is known in relation to whether or not they relate to non-technical energy losses;
samples within the context of the cases for which the output in relation to whether or not they relate to non-technical energy losses is not known ex ante, but for which the absence of non-technical losses is assumed;
records for which the quality of whether or not they correspond to non-technical losses is not known ex ante, and for which the probability of assuming a pre-established condition is the lowest, the probability being evaluated using a classifier.

For the present invention, it is advantageous to use training records relating to samples in which it is known or estimated, even without this being known ex ante, that the sample represented by the data record corresponds to a condition of absence of non-technical loss.

An autoencoder trained to reconstruct, during the recoding step, the input record corresponding to a condition of absence of non-technical losses, and therefore due to technical losses, is expected to have a poor ability to correctly reconstruct data records relating to conditions of non-technical energy losses, i.e. malfunctions or fraudulent causes.

The outcome relating to the condition of presence or absence of non-technical loss for a sample represented by a combination of information each described with a corresponding variable is obtained by comparing the input record and the record obtained at output, after the decoding and recoding process performed by the autoencoder.

The evaluation of the outcome of the comparison between the output record and the input record can be performed by defining a pre-established distance metric of the two records, or by means of functions that measure the difference and threshold values with which to compare the values calculated with the distance metrics and/or with the functions. These evaluation steps can also be performed by means of other methods for determining a measure of correspondence between the input record and the output record.

Given the above, therefore, the method according to embodiments described herein provides a step of evaluating the correspondence between the input record to the autoencoder and the reconstructed output record, which provides the steps of determining a scale of correspondence values and a threshold value on the basis of which to discriminate the reconstructed records that are to be considered corresponding to the input records, and the reconstructed records that are to be considered not corresponding to the input records, the outcome of correspondence being associated with an evaluation of absence of non-technical loss and the outcome of non-correspondence being associated with a condition of presence of non-technical loss, and the outcome being used to generate one or more of the following activities:
generation of a suggestion or an order for the execution of a technical inspection to verify, in the field, the condition of the network and its operating units, such as concentrators and/or meters in particular;
opening of administrative activities aimed at carrying out legal actions and/or recovering the cost of the energy relating to the non-technical loss, if the outcome of the inspection were to confirm the condition detected by the algorithm.

The above-mentioned activities are to be considered purely indicative, and it is possible to provide other and different actions following the outcome of the processing using the autoencoder.

According to another characteristic, the information relating to the training records and the input records for the qualitative determination of whether the sample is to be considered a case relating to a condition of presence or absence of non-technical loss can comprise, in addition to the aforementioned electrical parameters and to the measurements relating to the time trend of the energy withdrawn, also other data of a demographic type.

Typically, the monitoring system of an electrical energy distribution network also provides, for each measuring station and in particular for each meter, relative data such as demographic data of the users of each withdrawal and/or generation unit, geographical data of each withdrawal and/or generation unit, weather data relating to each withdrawal and/or generation unit, time data such as year, month and time, or a combination of part or of all types of such data.

The demographic data allow to introduce into the prediction calculation data relating to the type of supply associated with a specific withdrawal unit, such as for example the type of current, the maximum power that can be delivered on the basis of the supply contract, the combination of the withdrawal unit with a local electrical energy generation unit and the technical specifications of the local electrical energy production unit.

The data relating to the geographical position are also relevant in relation to whether the withdrawal and/or generation unit belongs to a sub-network, as well as for example the seasonal and/or daily trend of the withdrawal of energy from the network and/or the generation and introduction of energy into the network.

As regards weather data, these can relate to the time trend of the weather conditions that has been recorded and stored for a pre-established geographical position of an energy withdrawal and/or generation unit, and which relates to a pre-established period of time prior to that of the prediction.

In relation to the temporal data to which the measurements refer, for example, these have an influence in relation to the withdrawal conditions or to the consumption's time trend, for example in relation to the fact that the detection period coincides with the day or night, or with particular events that are typically connected to variations in consumption with respect to the daily average, such as holiday periods, periods relating to particular festivities or even temporal coincidences with the occurrence of events that modify users' normal behavior.

As regards the identification of the training records relating to cases with the lowest probability of corresponding or not to a condition of non-technical loss, according to one characteristic of embodiments described herein, the method provides a preliminary step of selecting these records by processing a classifier, trained in a supervised manner on the inspection history (for which information on the presence or absence of non-technical loss is available) which supplies at output an estimate of the probability of the presence or absence of non-technical losses.

An embodiment can provide that the classifier consists of a machine learning algorithm, such as a neural network subjected to supervised or unsupervised training, such as for example the classifiers known in the state of the art for determining the presence or absence of non-technical losses.

Alternatively, the aforementioned preliminary step of selecting these records with a low probability of presence of non-technical losses can occur through the use of expert systems based on statistical analyses of the inspection history, for which there is information on the presence or absence of non-technical losses.

As regards the type of data summarized above by categories, a detailed analysis can provide many categories of data that are normally available to companies that deal with the distribution of energy and in particular of electrical energy.

According to one embodiment, it is possible to use a machine learning algorithm that, among the individual categories of data that form the autoencoder's training records, selects one or more categories of data whose variation has a greater effect on determining the condition of presence or absence of non-technical losses.

One example of a machine learning algorithm that allows to carry out such an operation of selecting the variables on the basis of their relevance to the output is described in document WO2004063831, which discloses techniques for optimizing datasets for training and testing and/or for identifying, among the variables provided in the training and testing data records and/or in the data records that describe cases to be processed by means of a trained algorithm, those variables that have a greater impact on the predictive process.

Alternatively, it is possible to use machine learning algorithms that project multidimensional maps on spaces having smaller dimensions, the dimensions of the multidimensional spaces each being relative to a variable or a combination of variables provided in a record of data that maps a sample intended for training, or for which the algorithm is applied in order to generate the prediction. A machine learning algorithm such as those known in the state of the art, in which a multidimensional space of records or variables is projected into a space having fewer dimensions, and therefore fewer independent variables or records, without losing essential information representative of the characteristics of the sample which are contained in the profile defined by the records and/or variables of a record.

Alternatively, it is also possible to select the variables that are essential to the performance of the autoencoder through domain adaptation processes.

It should be noted that these optimization steps are preprocessing steps that are not essential to the resolution of the technical problem underlying the invention, which is solved thanks to the choice of the autoencoder as a machine learning algorithm; however, they make the autoencoder more effective and increase its performance, both in terms of the effort required to collect the data relating to the categories thereof in order to photograph a user profile with reference to the determination of whether or not energy consumption anomalies relating to the user are due to the presence or absence of non-technical losses, and also in terms of the computational burden, as well as in relation to the fitness of the result yielded by the algorithm.

Although the examples of optimization methods in relation to the selection of variables representative of the characteristics discriminating the conditions of presence or absence of non-technical losses may still appear complex from an implementation point of view, it should be considered that in general these optimization steps do not have to be repeated every time an analysis using the autoencoder is performed, but the optimization steps are limited to a single execution in an initial step of determining the characteristics relating to the variables to be considered for the generation of the records to be supplied to the algorithm that defines, once and for all, the structure of the database in relation to the different categories of data to be used, avoiding overloading the autoencoder algorithm with noise.

As regards the coding of the data which constitute each record of the training dataset, but which also constitute the input data for which the presence or absence of non-technical loss has to be verified, this coding can be performed by defining, for each datum relating to measured physical quantities, such as energy supply electrical parameters, energy withdrawal time trend in a pre-established time window, determination of temporal data that define instants and/or periods to which the measurements refer and/or also the demographic-type data defined above, a parametric variable that can assume pre-established values with reference to a pre-established scale of values, and that is well defined from the point of view of the type of variable in relation to the values it can assume. Typically, a metric scale can be continuous or discontinuous, or only present the possibility of assuming pre-established values that define qualitative and/or status conditions.

The variables and the values that they assume based on the measurements and/or the administrative data form a vector, of which they constitute the components in a multidimensional space whose dimension corresponds to the number of variables.

Embodiments described herein also concern a system configured to implement the method as in one or more of the embodiments described above, which system comprises at least one processing unit with at least one memory in which a software is stored, in which software the instructions for the execution of at least one autoencoder algorithm are encoded, and which software makes the processing unit capable of executing the steps provided by the algorithm on one or more input data records;
at least one interface for loading one or more records which comprise data relating at least to electrical parameters and/or to measurements of the time trend of the withdrawal of electrical energy in one or more measuring stations, and which data constitute the input data to the autoencoder algorithm;
at least one comparator of an input record with a record reconstructed in output by the autoencoder, which comparator executes a software for comparing and evaluating the outcome of the comparison, which comprises the instructions for setting one or more measurement metrics of one or more variables representing the differences between input record and output record reconstructed by the autoencoder and for calculating the value of the one or more variables, and the instructions for setting a pre-established common and/or specific threshold value for the one or more variables, on the basis of which threshold value it is defined whether the value of the one or more variables corresponds to the presence or absence of non-technical losses relating to the sample represented by the data of the input record.

According to yet another characteristic, the system can comprise a memory in which a program is loaded for activating communication activities of the outcome of the processing and/or activation of one or more technical verification and/or administrative intervention actions.

In one embodiment, the interface for loading one or more records that comprise data relating at least to electrical parameters and/or to measurements of the time trend of the withdrawal of electrical energy in one or more measuring stations, and which data constitute the input data to the autoencoder algorithm, is a communication interface with a system for monitoring the operating conditions of an electrical distribution network and/or an administrative management system of the administrative activities relating to the supply of electrical energy through the electricity distribution network.

According to yet another characteristic, which can be provided in combination with one or more of the embodiments or characteristics of the system previously described, the processing unit can comprise at least one memory in which software is stored that makes the processing unit capable of executing a training step of the autoencoder algorithm.

In combination with the training step of the autoencoder algorithm, according to another characteristic, the processing unit can comprise at least one memory in which a software is stored that comprises the instructions for the processing unit relating to a step of preventive processing of the data provided for the input record, the software comprising the instructions for the execution, by the processing unit, of processing steps of the records provided by one or by a combination of one or more of the following algorithms: a machine learning algorithm or a combination of machine learning algorithms for optimizing and/or selecting the descriptive variables of data provided for the input records, a machine learning algorithm such as a classifier or a clustering mechanism for determining the probabilities that a pre-established record is associated with the presence or absence of non-technical losses, an algorithm for projecting the records from an initial multidimensional space to a multidimensional space with fewer dimensions than the initial one, a domain adaptation algorithm.

According to one embodiment, the above-described system can be part of a service platform that is configured to manage and optimize field interventions for the verification of suspected fraud or for the verification of energy loss, the platform consisting of a plurality of tools consisting of computer implemented subsystems which provide functionalities for access, consultation, correlation and/or graphic representation of data relating to status and operational parameters of the network and of the devices for measuring the energy withdrawn, and data relating to outcomes of field inspections, as well as demographic data and other categories of data which may have an influence on the identification of the presence or absence of non-technical losses and/or for defining intervention priorities and management of interventions.

According to one embodiment, the system, both individually and also within the context of the aforementioned platform, can be provided in combination with a subsystem that is configured as a software tool executable by one or more processors to calculate the overall amount of energy subject to the loss, in particular the non-technical loss.

In one embodiment, this value relating to the overall energy consumption attributable to the loss allows, for example, among other possible functions, to generate execution priorities of the inspection activities in a sequence of scheduled inspections.

Other characteristics are the subject of the claims included below.

### DESCRIPTION OF THE DRAWINGS

These and other characteristics and advantages of the present invention will become clearer from the following description of some example embodiments, shown in the attached drawings wherein:
Figure 1 shows a high-level block diagram of a system according to an embodiment of the present invention.
Figure 2 shows a schematic of the structure of a neural network configured to operate as an autoencoder.
Figure 3 schematically shows an executive example of a possible combination of data categories that can be present in a data record which are representative of the presence or absence of non-technical losses.
Figure 4 shows a block diagram relating to the training phase.
Figure 5 is a flowchart describing an executive example of the sequence of steps of a method according to the present invention.

We must clarify that the phraseology and terminology used in the present description, as well as the figures in the attached drawings also in relation as to how described, have the sole function of better illustrating and explaining the present invention, their purpose being to provide a non-limiting example of the invention itself, since the scope of protection is defined by the claims.

To facilitate comprehension, the same reference numbers have been used, where possible, to identify identical common elements in the drawings. It is understood that elements and characteristics of one embodiment can be conveniently combined or incorporated into other embodiments without further clarifications.

### DESCRIPTION OF SOME EMBODIMENTS

With reference to the drawings, these show non-limiting example embodiments of the system and method of the present invention.

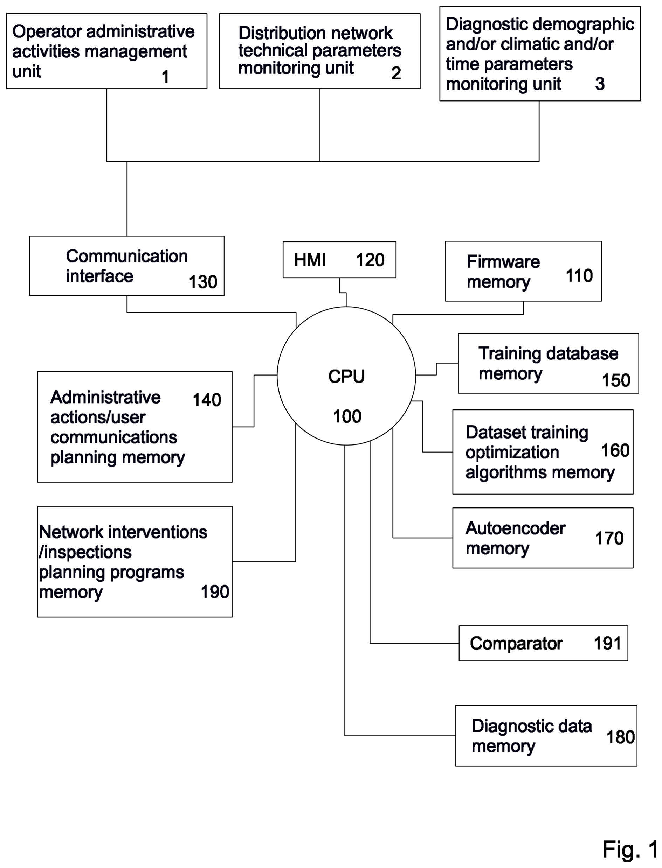

Fig. 1 shows a high-level block diagram of an embodiment of a system according to the present invention.

The system comprises a processing unit for executing the processing steps of the data present in the input records and which interfaces for access to such data with a technical and administrative management system of an operator of an electrical distribution network.

The technical and administrative management system of an electrical distribution network comprises, in the embodiment shown, a unit for managing administrative activities, such as for example invoicing, communication with customers, drafting of contracts, planning of field intervention activities for maintenance and/or new connections and other activities, and which is indicated with 1 in the drawing. The unit indicated with 2 relates to a unit for monitoring technical parameters of the distribution network. The distribution network provides the presence of different measuring stations, both relative to the terminal withdrawal units for individual users, such as meters or PODS for example, and also measuring units in nodes from which the lines branch out toward a plurality of utilities, called concentrators for example.

In this case, it is normal for differences to exist between the measurements of the trend of the energy withdrawn in correspondence with the measuring stations at the nodes branching out toward the individual utilities, and the sum of the trends of the energy withdrawal measured at the individual withdrawal units, i.e. the PODS. These differences can be systematic and related to physical phenomena such as, for example, energy consumption due to the Joule effect or other phenomena, and in this case the energy losses are defined as technical.

In other cases, the energy losses may result from malfunctions of the operating units provided in the network, such as for example the same measuring units provided in the various stations, or damage to the lines or even fraudulent actions, i.e. theft of electrical energy carried out by bypassing the withdrawal units provided for the user.

In addition, the management system can be provided with one or more additional units summarized in block 3 and which are related to the monitoring of demographic and/or climatic and/or time parameters related to the operation of the network.

By demographic parameters we mean both the conditions provided by the contract and relating to the configuration of the energy supplied in relation to parameters such as maximum allowed power, type of current such as single-phase or three-phase for example, voltage, supply limitations in relation to time parameters (day or night supply) or seasonal parameters, geographical position of the withdrawal units and also user profiling data. For climatic data, the meaning of the term is clear and can be related to the climatic zone in which a withdrawal station is located or to transient climatic events that have, for example, modified the climatic condition from the expected seasonal averages. Time data can refer to times or dates when certain events and/or measurements occurred. The list above is to be considered purely indicative and not exhaustive, since it is possible to provide additional categories of data that may be functional to the characterization of samples in order to qualitatively determine the type of losses recorded on the network.

A processing unit interfaces with the units of the technical and administrative management system of the network operator, by means of a communication interface 130. In a high-level embodiment as the one shown, the processing unit has at least one CPU 100 that manages different peripherals. In different areas of a common mass memory, or in dedicated memories indicated with 110, 140, 150, 160, 170, 180 190, 191, software are stored in which the instructions executable by the CPU are encoded, and which when executed make the CPU capable of executing certain functionalities, and in particular the method according to the present invention.

The memory indicated with 110 comprises a peripheral management firmware containing instructions to make the peripherals capable of performing the functions provided.

The memory indicated with 150 contains a software that comprises the instructions to carry out the training of the autoencoder algorithm and the memory 170 contains a software that comprises the instructions to make the CPU capable of performing the steps provided by the algorithm.

The memory 160 contains an optional software comprising the instructions for the CPU 100 which, when executed, make the CPU capable of performing steps of optimization of the training database, both from the point of view of the number of variables and also the type of data relating to the variables.

The memory 191 contains a software that comprises the instructions that when executed by the CPU make it capable of making comparisons between the input records and the output records of the autoencoder algorithm, and of determining the condition of technical or non-technical loss, based on the outcome of this comparison.

The memory 180 provides a software relating to internal diagnostics of the processing unit.

The memories 140 and 190 comprise programs for the planning of administrative actions and/or administrative communications with users and planning of interventions on the network, for example inspections by technical personnel that are activated following the outcome of the determination of the type of loss, either technical or non-technical, and which are transmitted, through the communication interface, to the network management unit represented schematically by units 1, 2 and 3.

It is possible to communicate with the CPU 100 and with the various peripherals by means of a human-machine interface indicated overall with 120. This can comprise various devices, such as display devices, selection devices, data string input devices and/or command devices. These devices can consist of one or more human-machine interface devices provided in current computers or computer systems.

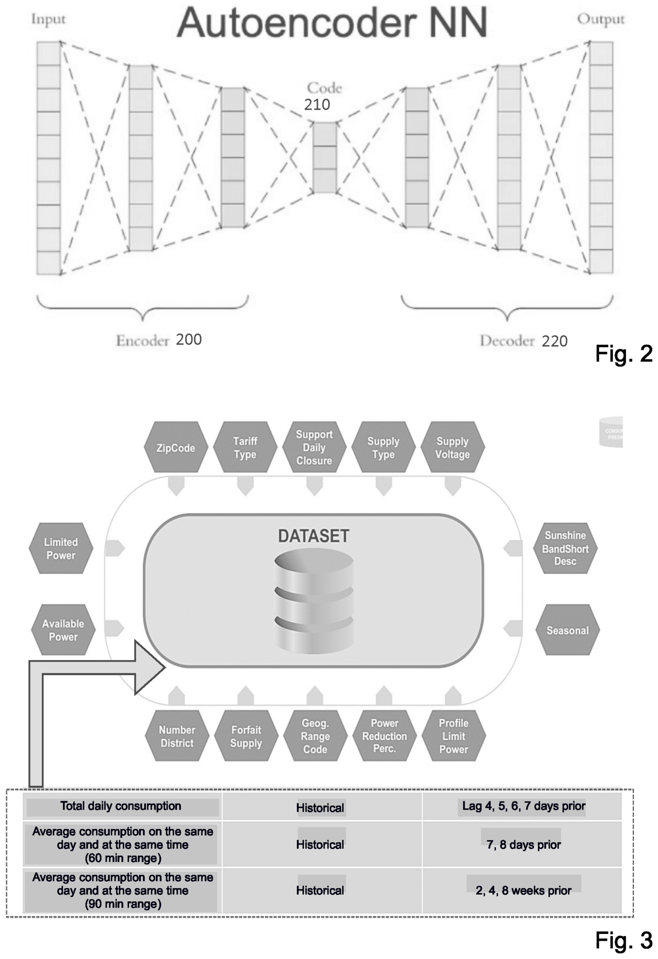

Fig. 2 shows a schematic of a neural network configured to act as an autoencoder. This network comprises an input layer with which the data comprised in a record relating to a sample to be analyzed or to a record of a training dataset are supplied to a so-called encoder 200, which comprises a predetermined number of hidden layers which have a decreasing number of nodes, for example according to a pattern that provides to halve the nodes with respect to the number of nodes of the previous layer. An example of a sequence of reducing the number of nodes between the layers of the encoder 200 so as to reach the number of nodes of the so-called queue layer can be 32, 16, 8 and 4. The encoding layer is the hidden input layer of the decoder 220 which provides to the reconstruction from the nodes of the encoding layer of a record corresponding to the input record and which provides an increase in the number of nodes from the queue layer 210 to the output layer. An example can provide a similar sequence to the one provided for the encoder 200, but executed in the opposite direction, whereby the nodes grow by doubling for each subsequent layer, going from 4, to 8 to 16 to 32, to end up in the output layer.

The number of input nodes and output nodes of the encoder 200 and decoder 220, respectively, generally corresponds to the number of variables present in the input record.

These are defined a priori based on the fact of being representative of the profiles of the samples that are associated with conditions of presence or absence of non-technical losses, and therefore of abnormal consumption due to malfunctions of the network and of the operating units that compose it, or to fraudulent actions of energy extraction.

At a more general level, the data present in a record to be used for qualitative determination to identify the presence or absence of non-technical losses provide, in combination, electrical parameters of the supply and records relating to time trends for a predetermined time window of the electrical energy withdrawals measured by a measuring station such as, for example, a meter or a similar withdrawal unit.

Additional data may be added to this data, as already highlighted above with reference to the example of fig. 1. Fig. 3 graphically shows a possible configuration of the category of data that can be represented by corresponding variables in the records relating to the training samples and to the samples to be subjected to evaluation.

In particular, fig. 3 shows a dataset of demographic characteristics, which demographic characteristics specifically comprise position characteristics such as post code, administrative characteristics such as tariff type, support for daily closure, type of supply, district number, forfeit supply, geographical range code, technical characteristics of the supply such as supply voltage, power limitation, available power, power reduction percentage, power limitation profile, climatic characteristics such as description of the duration of the day, seasonal conditions. The example is to be considered non-limiting, but exemplary, and other characteristics can be provided in addition to those shown, and also the characteristics relating to the time trends of the consumption measured by a withdrawal unit, such as a meter or a pod, or by a combination of one or more pods whose time trends have been measured in different pre-established time intervals and in pre-established time instants with pre-established frequencies for the repetition of such measurements. The combination of data shown with reference to fig. 3 does not constitute an exhaustive combination of data categories, but may vary widely with respect to the number and type of different data categories.

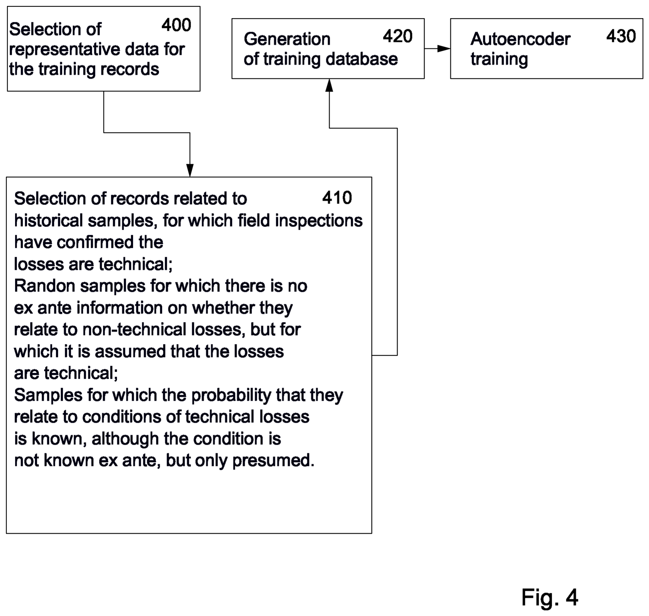

Fig. 4 schematically shows the steps of training the autoencoder. The step 400 provides that a selection is made regarding the categories of the data representative of the training records as a function of the qualitative determination of the type of losses. Advantageously, the autoencoder algorithm, since it is of an unsupervised type, allows to draw on samples that do not fall within a domain of historical samples for which the condition of the type of loss has been ascertained on the basis of an inspection, but which are comprised in the entire set of possible samples.

Preferably, the samples selected to generate the training records relate to historical samples for which field inspections have confirmed the absence of non-technical losses, to random samples for which there is no ex ante information on the presence or absence of non-technical losses, but for which the absence of technical losses is assumed, and to samples for which the probability that these are related to conditions of technical losses is known even if the condition is not known ex ante, but only presumed.

Therefore, the algorithm training is performed only on samples that are actually or presumably representative of conditions of absence of non-technical losses and therefore not due to malfunctions of the network or of the measuring systems, or to fraudulent actions of energy withdrawal.

Once the samples have been defined, the records relating to them are generated by using the data selected in the previous step and the training database with which the algorithm is trained is thus built 420.

It appears clear that since the autoencoder algorithm is trained on samples relating to conditions of absence of non-technical losses (TPE=0), or assumed as such, when the data of a record relating to a sample to be subjected to verification relates to a non-technical loss, the decoder algorithm is unable to reconstruct the input record in the output record, and therefore the comparison between the input record and the reconstructed output record allows to identify and classify, with a good level of reliability, the qualitative condition of the loss recorded as related to non-technical losses.

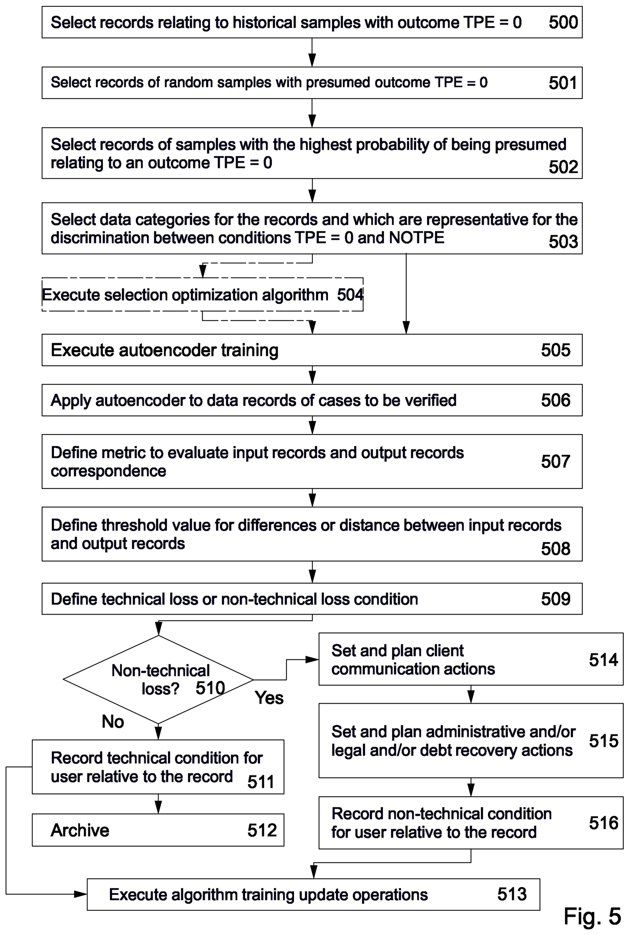

As will also be clear from the example of fig. 5, the step of selecting the categories of data representative of the training records indicated with 400 can be performed in a step of prior analysis of a set of different categories of data, using algorithms for the identification of independent variables and/or for the projection of data from multidimensional spaces with predetermined dimensions onto spaces having a smaller number of dimensions, or by domain adaptation algorithms or combinations thereof. These are machine learning algorithms or combinations of machine learning algorithms, such as for example those relating to the state of the art documents mentioned at the beginning.

Fig. 5 shows a flow chart of an executive example of the method according to the present invention.

Step 500 provides the selection of records relating to historical samples with a known outcome corresponding to the condition of absence of non-technical loss (TPE=0). Subsequently, in step 501, random samples with the presumed outcome of technical loss are selected, and finally, in step 502 records relating to samples with the highest probability of being presumed relating to an outcome of absence of non-technical loss are selected.

In step 503, the data categories for the records are selected, which are representative of the discrimination between the conditions of technical loss and non-technical loss.

Step 504 is an optional step of optimizing the selection using machine learning algorithms, as already described above and indicated with 504.

In step 505, the records selected in the previous steps are used to perform the training of the autoencoder that is applied to a record of cases to be subjected to verification in step 506. These records are obviously structurally configured both by number of categories and also by type, as the training records.

In step 507, a metric is defined to evaluate the differences between the input records to the autoencoder and the record reconstructed in output by the autoencoder.

In step 508, a threshold is defined with reference to the previously defined metric, on the basis of which it is possible to evaluate the distance or difference between input records and output records and therefore determine, on the basis of the comparison between distance or differences defined by the metric and the threshold value, whether the qualitative condition corresponds to the presence or absence of non-technical losses at step 509 and 510.

In the event of absence of technical losses, it is possible to provide to record this condition by associating it with the sample subjected to verification, as indicated in step 511, and provide to archive the verification. The result of the processing can possibly be used for an algorithm training update process, as indicated in step 513.

If the outcome of the comparison indicates the presence of a non-technical type loss, it is possible to set one or more of the steps, such as for example setting up the planning of actions of communication to the user relating to the sample subjected to verification, step 514, setting up and planning administrative and/or legal and/or debt recovery actions. Step 515, record the non-technical condition for the user relating to the sample under examination, step 516 after a field verification has been planned and performed by technical personnel, which resulted in a confirmation of the non-technical condition of the loss attributable to the user, or be limited to maintenance activities when the non-technical loss is related to network malfunctions and not attributable to the user.

According to embodiments, combinable with all embodiments described herein, a method for determining losses due to non-physical and non-systematic effects of electrical energy in an electrical distribution network is provided. Such network comprises a plurality of stations for measuring time series of different electrical parameters which characterize the conditions of withdrawal of the electrical energy in the various stations and the time trend of the quantity of electrical energy withdrawn measured at the various stations, i.e. the consumption of electrical energy at said measuring stations and wherein at least said data relating to one or more of said electrical parameters and/or the time trend of the quantity of electrical energy withdrawn from said network in correspondence with said one or more measuring stations, are analyzed to determine whether any loss of energy is due to a systematic physical factor or to an anomaly resulting from incidental malfunctions of the network or from abusive withdrawals of electricity. Such analysis being performed by means of a machine learning algorithm trained to classify said one or more measured data as relating to losses due to systematic physical effects or losses due to malfunctions of the network or to actions of abusive energy withdrawals. Said algorithm consists of a so-called autoencoder, which is trained on a dataset comprising at least said one or more electrical parameters and the data relating to the measurements of the trends of the electrical energy withdrawn from the network or consumption.

According to further embodiments, the training 430 of the autoencoder is performed using records comprising
data from different datasets and which consist at least of data relating to the electrical parameters of the supply and to the time trend of the energy withdrawn relative to all historical cases that have been subject to inspection and for which the output is known in relation to whether they relate to the presence or absence of non-technical energy losses;
random samples within the cases for which the output regarding being related to technical losses and non-technical losses is not known ex-ante but is assumed to have a pre-established state;
records for which the quality of whether or not they correspond to non-technical losses is not known ex ante and for which said probability of assuming a pre-established condition is the lowest, said probability being evaluated using a classifier.

According to further embodiments, training records relating to samples are used in which it is known or estimated even without this being known ex ante that the sample represented by the data record corresponds to a condition of absence of non-technical loss.

According to further embodiments, a step is provided for evaluating the correspondence between the input record to the autoencoder and the reconstructed output record which provides the steps of determining a scale of correspondence values and a threshold value on the basis of which to discriminate the reconstructed records that are to be considered corresponding to the input records and the reconstructed records that are to be considered not corresponding to the input records, the outcome of correspondence being associated with an evaluation of absence of technical loss and the outcome of non-correspondence being associated with a condition of non-technical loss and said outcome being used to generate one or more of the following activities:
request of information from the user;
generation of a suggestion or order for the execution of a technical inspection to verify in the field the condition of the network and its operating units, such as concentrators and/or meters in particular;
opening of administrative activities aimed at carrying out legal actions and/or recovering the cost of the energy relating to the non-technical loss if the outcome of the inspection were to confirm the condition detected by the algorithm.

According to further embodiments, the information relating to the training records and to the input records for the qualitative determination of whether the sample is to be considered a case relating to a non-technical loss condition or to a technical loss condition can comprise, in addition to the aforementioned electrical parameters and to the measurements relating to the time trend of the energy withdrawn, also further demographic data.

According to further embodiments, the lower probability of corresponding to a condition of absence of non-technical loss is determined through a preliminary step of selecting these records by processing a classifier, such as for example state of the art classifiers for determining the presence or absence of non-technical losses.

According to further embodiments, the type of data categories is selected by means of a machine learning algorithm which selects, from the individual categories of data that form the training records of the autoencoder, one or more categories of data whose variation has a greater effect on determining the condition of presence or absence of non-technical losses.

Further embodiments, combinable with all embodiments described herein, relate to a system configured to implement said method according to the above embodiments, which system comprises at least one processing unit 100 with
at least one memory 170 in which a software is stored, in which software the instructions for the execution of at least one autoencoder algorithm are encoded and which software makes said processing unit (100) capable of executing the steps provided by the algorithm on one or more input data records;
at least one interface 130 for loading one or more records which comprise data relating at least to electrical parameters and/or measurements of the time trend of electricity withdrawal in one or more measuring stations and which data constitute the input data to said autoencoder algorithm;
at least one comparator 191 of an input record with a reconstructed output record, which comparator 191 executes software for comparing and evaluating the outcome of said comparison which comprises the instructions for setting one or more measurement metrics of one or more variables representing the differences between input record and reconstructed output record and calculating the value of said one or more variables and the instructions for setting a pre-established common and/or specific threshold value for said one or more variables, based on which threshold value it is defined if the value of said one or more variables corresponds to a condition of presence or absence of non-technical losses relating to the sample represented by the input record data,
said system comprises a memory 140, 190 in which a program is loaded for activating communication activities of the outcome of the processing and/or activating one or more technical verification and/or administrative intervention actions.

According to further embodiments, the interface 130 for loading one or more records, which comprise data relating at least to electrical parameters and/or measurements of the time trend of the electricity withdrawal in one or more measuring stations and which data are the input data to said autoencoder algorithm, is a communication interface 130 with a system for monitoring the operating conditions of an electrical distribution network and/or an administrative management system of the administrative activities relating to the supply of electricity through said electricity distribution network.

According to further embodiments, the processing unit 100 can comprise at least one memory 150 in which a software is stored which makes said processing unit 100 capable of executing a training step of said autoencoder algorithm.

According to further embodiments, the processing unit 100 can comprise at least one memory 160 in which a software is stored which comprises the instructions for said processing unit 100 relating to a step of preventive processing of the data provided for the input record, said software comprising the instructions for the execution by said processing unit 100 of processing steps of said records provided by one or by a combination of one or more of the following algorithms: a machine learning algorithm or a combination of machine learning algorithms for optimizing and/or selecting the descriptive variables of data provided for the input records, a machine learning algorithm such as a classifier or a clustering algorithm for determining the probabilities that a pre-established record is associated with the condition of presence or absence of non-technical losses, an algorithm for projecting the records from an initial multidimensional space to a multidimensional space with fewer dimensions than the initial one, a domain adaptation algorithm.

It is clear that modifications and/or additions of parts may be made to the method and system as described heretofore, without thereby departing from the field and scope of the present invention, as defined by the claims.

It is also clear that, although the present invention has been described with reference to some specific examples, a person of skill in the art will be able to achieve other equivalent forms of method and system, having the characteristics as set forth in the claims and hence all coming within the field of protection defined thereby.

In the following claims, the sole purpose of the references in brackets is to facilitate their reading and they must not be considered as restrictive factors with regard to the field of protection defined by the claims.

## Claims

1. Method for determining losses due to non-physical and non-systematic effects of electrical energy in an electrical distribution network, which network comprises a plurality of stations for measuring time series of electrical parameters which characterize the consumption of electrical energy at said measuring stations and wherein data relating to one or more of said electrical parameters are analyzed to determine whether any loss of energy is due to a systematic physical factor or to an anomaly resulting from incidental malfunctions of the network or from abusive withdrawals of electricity, said analysis being performed by means of a machine learning algorithm trained to classify said data as relating to losses due to systematic physical effects or losses due to malfunctions of the network or to actions of abusive energy withdrawals, said method being **characterized in that** said algorithm consists of a so-called autoencoder, which is trained on a dataset comprising at least said one or more electrical parameters.

2. The method according to claim 1, wherein the training (430) of the autoencoder is performed using records comprising
data from different datasets and which consist at least of data relating to the electrical parameters of the supply and to time trend of the energy withdrawn relative to all historical cases that have been subject to inspection and for which the output is known in relation to whether they relate to the presence or absence of non-technical energy losses;
random samples within the cases for which the output regarding being related to technical losses and non-technical losses is not known ex-ante but is assumed to have a pre-established state;
records for which the quality of whether or not they correspond to non-technical losses is not known ex ante and for which said probability of assuming a pre-established condition is the lowest, said probability being evaluated using a classifier.

3. Method according to claim 2, wherein training records relating to samples are used in which it is known or estimated even without this being known ex ante that the sample represented by the data record corresponds to a condition of absence of non-technical loss.

4. Method according to one or more of the previous claims, wherein a step is provided for evaluating the correspondence between the input record to the autoencoder and the reconstructed output record which provides the steps of determining a scale of correspondence values and a threshold value on the basis of which to discriminate the reconstructed records that are to be considered corresponding to the input records and the reconstructed records that are to be considered not corresponding to the input records, the outcome of correspondence being associated with an evaluation of absence of technical loss and the outcome of non-correspondence being associated with a condition of non-technical loss and said outcome being used to generate one or more of the following activities:
request of information from the user;
generation of a suggestion or order for the execution of a technical inspection to verify in the field the condition of the network and its operating units, such as concentrators and/or meters in particular;
opening of administrative activities aimed at carrying out legal actions and/or recovering the cost of the energy relating to the non-technical loss if the outcome of the inspection were to confirm the condition detected by the algorithm.

5. Method according to one or more of the previous claims, wherein the information relating to the training records and to the input records for the qualitative determination of whether the sample is to be considered a case relating to a non-technical loss condition or to a technical loss condition can comprise, in addition to the aforementioned electrical parameters and to the measurements relating to the time trend of the energy withdrawn, also further demographic data.

6. Method according to one or more of the previous claims, wherein the lower probability of corresponding to a condition of absence of non-technical loss is determined through a preliminary step of selecting these records by processing a classifier, such as for example state of the art classifiers for determining the presence or absence of non-technical losses.

7. Method according to one or more of the previous claims, wherein the type of data categories is selected by means of a machine learning algorithm which selects, from the individual categories of data that form the training records of the autoencoder, one or more categories of data whose variation has a greater effect on determining the condition of presence or absence of non-technical losses.

8. System configured to implement a method according to one or more of the previous claims, which system comprises at least one processing unit (100) with
at least one memory (170) in which a software is stored, in which software the instructions for the execution of at least one autoencoder algorithm are encoded and which software makes said processing unit (100) capable of executing the steps provided by the algorithm on one or more input data records;
at least one interface (130) for loading one or more records which comprise data relating at least to electrical parameters which data constitute the input data to said autoencoder algorithm.

9. System according to claim 8, further comprising at least one comparator (191) of an input record with a reconstructed output record, which comparator (191) executes software for comparing and evaluating the outcome of said comparison which comprises the instructions for setting one or more measurement metrics of one or more variables representing the differences between input record and reconstructed output record and calculating the value of said one or more variables and the instructions for setting a pre-established common and/or specific threshold value for said one or more variables, based on which threshold value it is defined if the value of said one or more variables corresponds to a condition of presence or absence of non-technical losses relating to the sample represented by the input record data, said system comprises a memory (140, 190) in which a program is loaded for activating communication activities of the outcome of the processing and/or activating one or more technical verification and/or administrative intervention actions.

10. System according to claims 8 or 9, wherein the interface (130) for loading one or more records, which comprise data relating at least to electrical parameters and/or measurements of the time trend of the electricity withdrawal in one or more measuring stations and which data are the input data to said autoencoder algorithm, is a communication interface (130) with a system for monitoring the operating conditions of an electrical distribution network and/or an administrative management system of the administrative activities relating to the supply of electricity through said electricity distribution network.

11. System according to any of claims 8 to 10, wherein the processing unit (100) can comprise at least one memory (150) in which a software is stored which makes said processing unit (100) capable of executing a training step of said autoencoder algorithm.

12. System according to claim 11, wherein the processing unit (100) can comprise at least one memory (160) in which a software is stored which comprises the instructions for said processing unit (100) relating to a step of preventive processing of the data provided for the input record, said software comprising the instructions for the execution by said processing unit (100) of processing steps of said records provided by one or by a combination of one or more of the following algorithms: a machine learning algorithm or a combination of machine learning algorithms for optimizing and/or selecting the descriptive variables of data provided for the input records, a machine learning algorithm such as a classifier or a clustering algorithm for determining the probabilities that a pre-established record is associated with the condition of presence or absence of non-technical losses, an algorithm for projecting the records from an initial multidimensional space to a multidimensional space with fewer dimensions than the initial one, a domain adaptation algorithm.
